# EUROPEAN PATENT APPLICATION

(11) **EP 3 605 772 A1**
(43) Date of publication of application: **05.02.2020**
(21) Application number: 19188991.4
(22) Date of filing: 30.07.2019
(51) Int. Cl.: H02J 1/14, H02J 3/14, H05K 7/14

(54) **DYNAMICALLY CONFIGURABLE ENERGY STORAGE UNIT**

(30) Priority: 03.08.2018 US 201862714164 P
(71) Applicant: GE Aviation Systems LLC, Grand Rapids, MI 49512 (US)
(72) Inventor: ASTEFANOUS, Christopher, Grand Rapids, MI 49512 (US); HAMDAN, Mahmoud, Grand Rapids, MI 49512 (US)
(74) Representative: Openshaw & Co.

(57) **Abstract**

A power supply system (26), including a set of energy storage units (24), each of the set of energy storage units (24) having a power output, a housing (28) configured to receive the set of energy storage units (24), an electrical backplane (50) with a backplane power output (66), and a controller module (30) configured to operate the power output operations of the power supply system (26).

## Description

### TECHNICAL FIELD

The disclosure relates to a method and apparatus for operating a power supply system and more specifically to supplying power from a set of energy storage units of the power supply system.

### BACKGROUND OF THE INVENTION

Electrical power distribution systems manage the allocation of power from energy sources to electrical loads that consume the distributed electrical power. In an aircraft, one or more turbine engines provide for propulsion of the aircraft, and can further provide mechanical energy to generate electricity that is supplied to a number of selectively interconnected power buses. The power buses can be selectively connected by way of contactors, and ultimately power a number of different accessories such as environmental control systems (ECS), in-flight entertainment systems, windshield deicing, galleys, fuel pumps, and hydraulic pumps, e.g., equipment for functions needed on an aircraft other than propulsion. For example, contemporary aircraft utilize electrical power for electrical loads related to avionics, motors, and other electric equipment.

### BRIEF DESCRIPTION

In one aspect, the present disclosure relates to a dynamic power supply system, including a set of energy storage units, each of the set of energy storage units having a power output, and a housing configured to receive the set of energy storage units and including an electrical backplane with a backplane power output, the electrical backplane connectable with the each of the set of energy storage unit power outputs, a power output configuration module adapted to selectably interconnect at least a subset of the energy storage unit power outputs with the backplane power output, and a controller module configured to operate the power output configuration module.

In another aspect, the present disclosure relates to a dynamic power supply system for an aircraft power distribution system, including a set of energy storage units, each of the set of energy storage units having a power output, a set of sensors configured to generate sensor data related to the set of energy storage units, and a housing configured to receive the set of energy storage units and including an electrical backplane with a backplane power output connected with the aircraft power distribution system, the electrical backplane connectable with the each of the set of energy storage unit power outputs, a power output configuration module adapted to selectably interconnect at least a subset of the energy storage unit power outputs with the backplane power output, and a controller module communicatively connected with the set of sensors and configured to operate the power output configuration module base at least in part on the generated sensor data.

### BRIEF DESCRIPTION OF THE DRAWINGS

In the drawings:
FIG. 1 is a top down schematic view of an example aircraft and power distribution system of an aircraft including an energy storage unit, in accordance with various aspects described herein.
FIG. 2 is a schematic illustration of the energy storage unit of FIG. 1, in accordance with various aspects described herein.
FIG. 3 is another schematic illustration of a power output configuration module for the energy storage unit of FIG. 2, in accordance with various aspects described herein.
FIG. 4 is an example isometric illustration of the energy storage unit of FIGS. 1-3, in accordance with various aspects described herein.

### DETAILED DESCRIPTION

Aspects of the present disclosure are described herein in the context of an aircraft, which enables production of electrical power from an energy source such as a turbine engine, jet fuel, hydrogen, etc., or, for example, from an electrical energy storage unit or device. However, it will be understood that the disclosure is not so limited and has general applicability to power distribution systems or electrical energy supplying configurations in non-aircraft applications, including other mobile applications and non-mobile industrial, commercial, and residential applications. For example, applicable mobile environments can include an aircraft, spacecraft, space-launch vehicle, satellite, locomotive, automobile, etc. Commercial environments can include manufacturing facilities or power generation and distribution facilities or infrastructure.

While "a set of" various elements will be described, it will be understood that "a set" can include any number of the respective elements, including only one element. The use of the terms "proximal" or "proximally" refers to moving in a direction toward another component, or a component being relatively closer to the other as compared to another reference point. Also as used herein, while sensors can be described as "sensing" or "measuring" a respective value, sensing or measuring can include determining a value indicative of or related to the respective value, rather than directly sensing or measuring the value itself. The sensed or measured values can further be provided to additional components. For instance, the value can be provided to a controller module or processor, and the controller module or processor can perform processing on the value to determine a representative value or an electrical characteristic representative of said value. Additionally, while terms such as "voltage", "current", and "power" can be used herein, it will be evident to one skilled in the art that these terms can be interrelated when describing aspects of the electrical circuit, or circuit operations.

All directional references (e.g., radial, axial, upper, lower, upward, downward, left, right, lateral, front, back, top, bottom, above, below, vertical, horizontal, clockwise, counterclockwise) are only used for identification purposes to aid the reader's understanding of the disclosure, and do not create limitations, particularly as to the position, orientation, or use thereof. Additionally, connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other. In non-limiting examples, connections or disconnections can be selectively configured, connected, or connectable to provide, enable, disable, or the like, an electrical connection between respective elements. Non-limiting example power distribution bus connections or disconnections can be enabled or operated by way of switching, bus tie logic, or any other connectors configured to enable or disable the energizing of electrical loads downstream of the bus, or between buses.

As used herein, a "system" or a "controller module" can include at least one processor and memory. Non-limiting examples of the memory can include Random Access Memory (RAM), Read-Only Memory (ROM), flash memory, or one or more different types of portable electronic memory, such as discs, DVDs, CD-ROMs, etc., or any suitable combination of these types of memory. The processor can be configured to run any suitable programs or executable instructions designed to carry out various methods, functionality, processing tasks, calculations, or the like, to enable or achieve the technical operations or operations described herein. The program can include a computer program product that can include machine-readable media for carrying or having machine-executable instructions or data structures stored thereon. Such machine-readable media can be any available media, which can be accessed by a general purpose or special purpose computer or other machine with a processor. Generally, such a computer program can include routines, programs, objects, components, data structures, algorithms, etc., that have the technical effect of performing particular tasks or implement particular abstract data types.

As used herein, a controllable switching element, or a "switch" is an electrical or electro-mechanical device that can be controllable to toggle between a first mode of operation, wherein the switch is "closed" intending to transmit current from a switch input to a switch output, and a second mode of operation, wherein the switch is "open" intending to prevent current from transmitting between the switch input and switch output. In non-limiting examples, connections or disconnections, such as connections enabled or disabled by the controllable switching element, can be selectively configured to provide, enable, disable, or the like, an electrical connection between respective elements.

The disclosure can be implemented in any electrical circuit environment having a switch. A non-limiting example of an electrical circuit environment that can include aspects of the disclosure can include an aircraft power system architecture, which enables production or supplying of electrical power from a power source (e.g. a generator or power storage unit or device), and delivers the electrical power to a set of electrical loads via at least one solid state switch, such as a solid state power controller (SSPC) switching device. One non-limiting example of the SSPC can include a silicon carbide (SiC) or Gallium Nitride (GaN) based, high power switch. SiC or GaN can be selected based on their solid state material construction, their ability to handle high voltages and large power levels in smaller and lighter form factors, and their high speed switching ability to perform electrical operations very quickly. Additional switching devices or additional silicon-based power switches can be included.

The exemplary drawings are for purposes of illustration only and the dimensions, positions, order and relative sizes reflected in the drawings attached hereto can vary.

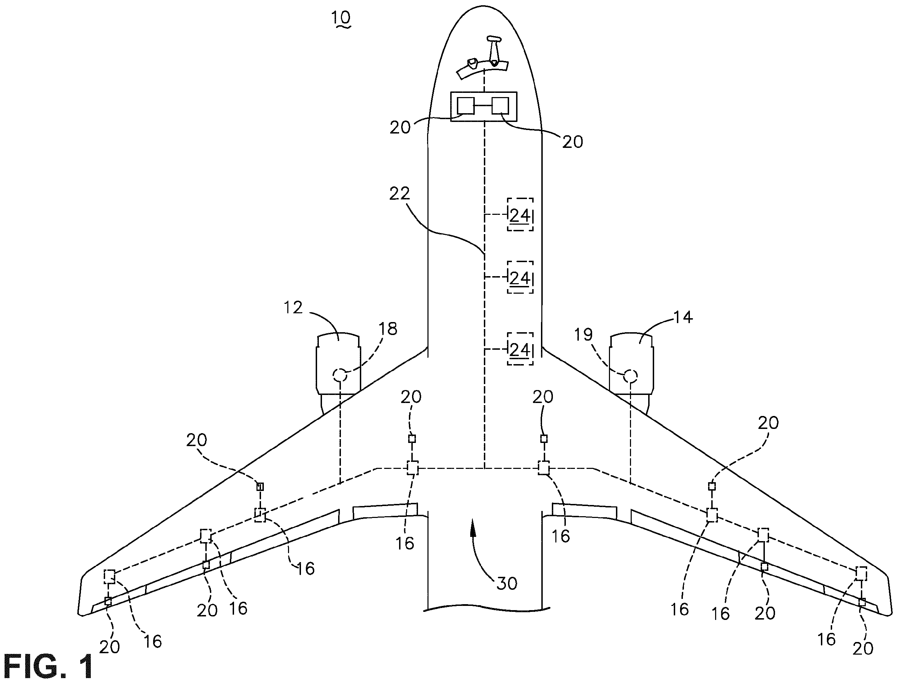

Referring now to FIG. 1, an aircraft 10 is shown having an exemplary power distribution system 30 including at least one turbine engine, shown as a left engine system 12 and a right engine system 14. Alternatively, the power system can have fewer or additional engine systems. The left and right engine systems 12, 14 can be substantially identical, and can further include at least one power source, illustrated respectively as a first generator 18 and a second generator 19. At least one of the first or second generators 18, 19 can include variable speed or variable output generators 18, 19. In this example, a variable speed or variable output generator 18, 19 can include a generator 18, 19 adapted or configured to operate within a predetermined range of input speed, gearbox speed ratios, or the like, and can generate a power output within a predetermined output range (e.g. voltage output range, current output range, frequency output range, or a combination thereof). In one non-limiting example, a variable output generator 18, 19 can include a generator adapted or configured to output approximately 115 Volts AC between 390 and 410 Hertz.

The left and right engine systems 12, 14 can further include another respective power source, such as a second electric machine or set of generators (not shown). Non-limiting aspects of the disclosure can be included wherein, for example, the left engine system 12 includes the first generator 18 as a primary power source and an additional generator as a secondary, back-up, or redundant power source. The aircraft is shown further having a set of power-consuming components, or electrical loads 20, such as for instance, an actuator load, flight critical loads, and non-flight critical loads.

The electrical loads 20 are electrically coupled with at least one of the generators 18, 19 via a power distribution system 30 including, for instance, power transmission lines 22, bus bars, power buses (or the like), and a set of power distribution nodes 16. The aircraft 10 can further include a set of supplemental power sources, such as a set of energy storage units 24, selectably connectable with the transmission lines 22, and operable to provide at least a portion of primary power, supplemental power, redundant power, backup power, emergency power, or the like. Non-limiting examples of the set of energy storage units 24 can include, but are not limited to, fuel cells, batteries, capacitors, supercapacitors, a "bank" or set of any of the aforementioned examples, or any other chargeable or dischargeable source(s) of electrical power. As shown, the set of energy storage units 24 can provide power to the set of transmission lines 22, and thus, the set of power distribution nodes 16 or the set of electrical loads 20.

In the aircraft 10, the operating left and right engine systems 12, 14 provide mechanical energy which can be extracted, typically via a spool, to provide a driving force for the set of generators 18, 19. The set of generators 18, 19, in turn, generate power, such as AC or DC power, and provides the generated power to the transmission lines 22, which delivers the power to the electrical loads 20, positioned throughout the aircraft 10. Furthermore, during operation, the set of energy storage units 24 can be selectably connected with the transmission lines 22, and operable to provide primary or supplemental power to a subset of the electrical loads 20.

Example power distribution management functions can include, but are not limited to, selectively enabling or disabling the delivery of power to particular electrical loads 20, depending on, for example, available power distribution supply, criticality of electrical load 20 functionality, or aircraft mode of operation, such as take-off, cruise, or ground operations. During emergency or inadequate periods of electrical power generation, including but not limited to engine or generator failure, at least one set of energy storage units 24 can be operated, enabled, or connected for providing power to the electrical loads 20. Additional management functions can be included.

It will be understood that while aspects of the disclosure are shown in an aircraft environment of FIG. 1, the disclosure is not so limited and can have applicability in a variety of environments. For example, while this description is directed toward a power system architecture in an aircraft, aspects of the disclosure can be further applicable to provide power, supplemental power, emergency power, essential power, or the like, in otherwise non-emergency operations, such as takeoff, landing, or cruise flight operations.

Furthermore, the number of, and placement of, the various components depicted in FIG. 1 are also non-limiting examples of aspects associated with the disclosure. For example, while various components have been illustrated with relative position of the aircraft 10 (e.g. the electrical loads 20 on the wings of the aircraft 10, etc.), aspects of the disclosure are not so limited, and the components are not so limited based on their schematic depictions. Additional aircraft 10 configurations are envisioned.

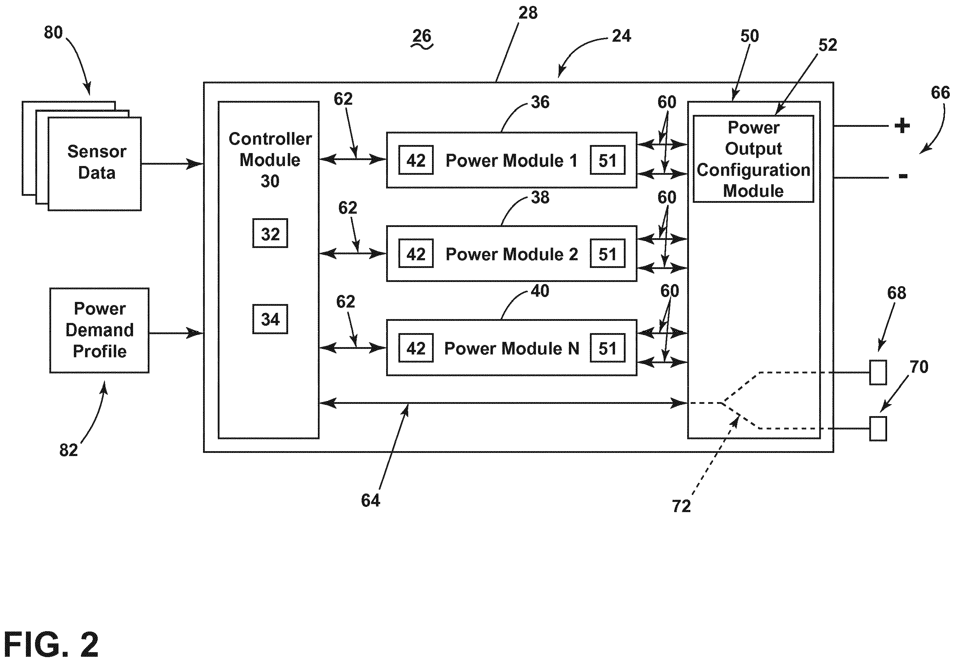

Referring now to FIG. 2, a schematic illustration of a power supply system 26, which can include a subset of the devices, configurations, or the like, of the exemplary power distribution system 30 of FIG. 1. As shown, the power supply system 26 can include at least one energy storage unit 24, and can optionally include, for example, a set of sensors 80 adapted or configured to provide sensor data to the energy storage unit 24, or a power demand profile 82 adapted or configured to be provided to the energy storage unit 24.

The energy storage unit 24 can include a housing 28, a controller module 30 having a processor 32 and memory 34, a backplane 50, and a set of energy storage modules adapted or configured to store a charge or amount of electrical energy, shown as a first power module 36, a second power module 38 and an "Nth" power module (e.g. "power module N" 40). Each respective power module 36, 38, 40 can include a controller module 42 (which can also include a processor and memory, but is not illustrated for brevity) and at least one electrical energy storage unit, shown schematically as a single energy storage cell 51. Non-limiting examples of the energy storage cell 51 can include a dischargeable DC power storage device, such as a battery, a battery bank, a battery cell, a super capacitor, a fuel cell, a hydrogen cell, or a continuously or semi-continuous power conversion or supplying device. While three power modules 36, 38, 40 are illustrated in the example, any number of power modules 36, 38, 40 can be included in aspects of the disclosure.

The controller module 30 or energy storage unit 24 can be communicatively connected with the optional set of sensors 80 to receive an optional set of sensor data, and can further be communicatively connected with the optional power demand profile 82 to receive an optional power demand profile. As used herein, the set of sensors 80 can be adapted to sense or measure aspects related to the power distribution system 30, the aircraft 10, the power supply system 26, or another system or component thereof. Non-limiting examples of data or measurements communicated to and received by the energy storage unit 24 from the set of sensors 80 can include power supply data (present supply data or future supply data), temperature, altitude, airspeed, humidity, vibration, electrical parameters, flight phase (e.g. climb, cruise, landing, ground, etc.), or the like. Non-limiting examples of power demand profile 82 can include data or profiles related to expected power demands of an electrical system, anticipated power demands of an electrical system, predicted or estimated power demands of an electrical system, specifics related to the power demand of a subcomponent of an electrical system (e.g. a motor, a light bulb, a high power demand when starting compared with a smaller power demand once operating), criticality of the component or electrical system, or the like.

The controller module 30 can also be communicatively connected with each of the set of power modules 36, 38, 40, for example, by way of a communication interface 62. In one non-limiting example, the communication interface 62 can include a data network, a communication bus, conductors, data packets, or the like. In another non-limiting aspect of the disclosure, the communication interface 62 can, for example, operate through the backplane 50. The controller module 30 can further be communicatively connected with the backplane 50 by way of a communication interface 64. The communication interfaces 62, 64 can be similar, but are separately noted and identified for understanding.

The backplane 50 can include a physical planar element having a set of physical or electrical connectors for connecting with the set of power modules 36, 38, 40 (for example, by way of power connections 60 or communication interfaces 62). The backplane 50 can further include a power output configuration module 52 adapted for dynamically configuring electrical connections between the set of power modules 36, 38, 40 and an energy storage unit 24 power output 66. As use here, "dynamically configuring electrical connections" can include selectively enabling or disabling a set of electrical connection that operably connect or disconnect (i.e. "interconnect") the set of power connections 60 with the power output 66. This can further include selectively enabling or disabling parallel arrangements between power connections 60 or respective power modules 36, 38, 40, selectively enabling or disabling series arrangements between power connections 60 or respective outputs of power modules 36, 38, 40, or a combination thereof. Aspect of the power output configuration module 52 can include switching elements, solid state switching elements, solid state power controllers (SSPCs), electro-mechanical switchable connectors, or the like.

In another non-limiting example, the energy storage unit 24 can include additional inputs, outputs, or combination input/outputs for further communicating other components or systems. For example, FIG. 2 illustrates a communications connector 68 for interfacing or communicating with another component or system, and a discrete communications connector 70 for communicating discrete indications or indicators to another component or system (e.g. a health monitoring status). As schematically shown, the communications connectors 68, 70 can further be communicatively connected with the controller module 30 by way of communication lines 64, 72. Additional or alternative interfaces can be included.

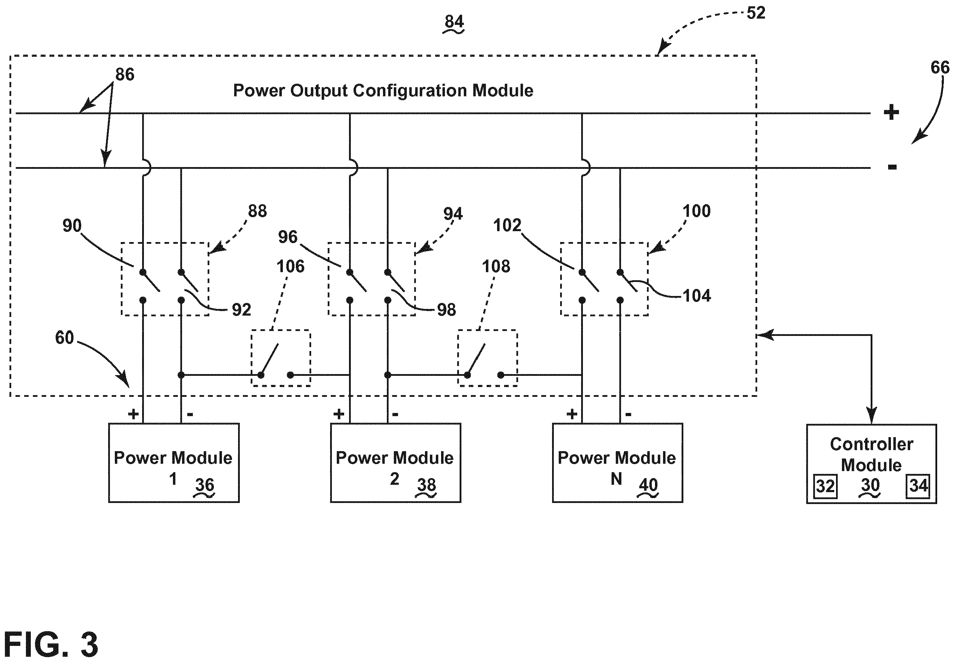

FIG. 3 illustrates a schematic representation 84 of the power output configuration module 52 of the energy storage unit 24. In one non-limiting example, the power output configuration module 52 can include a set of power bus bars 86 (for example, integrated into the backplane 50 (not shown). The bus bars 86 can be selectively connected with each respective power module 36, 38, 40 by way of a set of controllable switching elements, as explained herein. For instance, the power connectors 60 of the first power module 36 can be selectively connected with the bus bars 86 by way of a first set of switching elements 88 including a first switch 90 and a second switch 92. In another instance, the power connectors 60 of the second power module 38 can be selectively connected with the bus bars 86 by way of a second set of switching elements 94 including a third switch 96 and a fourth switch 98. In yet another instance, the power connectors 60 of the Nth power module 40 can be selectively connected with the bus bars 86 by way of a third set of switching elements 100 including a fifth switch 102 and a sixth switch 104.

The power connections 60 of the respective set of power modules 36, 38, 40 can further be selectively connected between each other, as shown. For example, the negative terminal of the first power module 36 power connections 60 can be selectively connected with the positive terminal of the second power module 38 power connections 60 by way of a seventh switch 106. Additionally, the negative terminal of the second power module 38 power connections 60 can be selectively connected with the positive terminal of the Nth power module 40 power connections 60, by way of an eighth switch 108. Each switch or set of switches 88-108 can be selectively operable in response to control signals or instructions generated by the controller module 30.

Thus, aspects of the backplane 50 can be included wherein the electrical association, connections, or the like, of the set of (or a subset of) the power modules 36, 38, 40 can be controllably configurable based on the desired, demanded, or otherwise controllable power output 66 of the energy storage unit 24. For instance, the enabling or disabling of the first, second, or third sets of switching elements 88, 94, 100 can selectively connect the respective set or subset of power modules 36, 38, 40 in parallel to the bus bars 86 and power output 66. In another instance, the set or a subset of the power modules 36, 38, 40 can be controllably configured in series. For instance, the combined closing of the first switch 90, the fourth switch 98, and the seventh switch 106 (assuming the remaining switches are open) can connect the first and second power modules 36, 38 in series and provide the series power output to the to the bus bars 86 and power output 66. In even yet another instance, the same series power output of the first and second power modules 36, 38 can be supplied to the bus bars 86 in parallel with the power output of the Nth power module 40 when the third set of switches 100 are also closed (assuming voltage outputs are similar). Any number of permutations, configurations, or arrangements can be controllably operated in aspects of the disclosure wherein the set of power modules 36, 38, 40 can provide a variable parallel, series, or combination thereof, set of power output arrangements. Furthermore, while not shown, aspects of the disclosure can be included wherein a set of switches are include to selective arrange any power module 36, 38, 40 in series with any other power module 36, 38, 40 (e.g. the first power module 36 operable in series with the Nth power module 40 without the intervening second power module 38 also in series).

In yet another instance, the variable parallel, series, or combination thereof, set of power output arrangements can further be selectively operated or enabled dynamically during power supplying operations (e.g. without performing maintenance operations or taking the energy storage unit 24 "offline" or "out of service"). Thus aspects of the disclosure can be included wherein the set of power modules 36, 38, 40 can house any energy storage medium, or a variety of dissimilar energy storage mediums, and the set of power modules 36, 38, 40 can be mixed and matched to maximize usage of energy or dischargeable power, as needed.

In another non-limiting aspect, the energy storage unit 24 or controller module 30 can also be adapted to determine the presence of one or more removable power modules 36, 38, 40, the amount of stored or dischargeable electrical energy in each respectively present power module 36, 38, 40, the health or operational status of each respectively present power module 36, 38, 40, or a combination thereof. For example, if a non-operational power module is determined to be present (e.g. received by the energy storage unit 24), the controller module or energy storage unit 24 can selectively disconnect the power connections 60 of that power module from the power output 66. In another non-limiting example, the energy storage unit 24 or controller module 30 can also be adapted to supply or discharge energy from the set or a subset of the power modules 36, 38, 40 based on an available state of charge of the set of power modules 36, 38, 40. In yet another non-limiting example the energy storage unit 24 or controller module 30 can also be adapted to supply or discharge energy from the set or a subset of the power modules 36, 38, 40 based on a power demand (e.g. transient demand can be supplied by discharging a supercapacitor-based power module compared with a continuous demand can be supplied by chemical-based batteries configured in parallel by the power output configuration module 52, etc.).

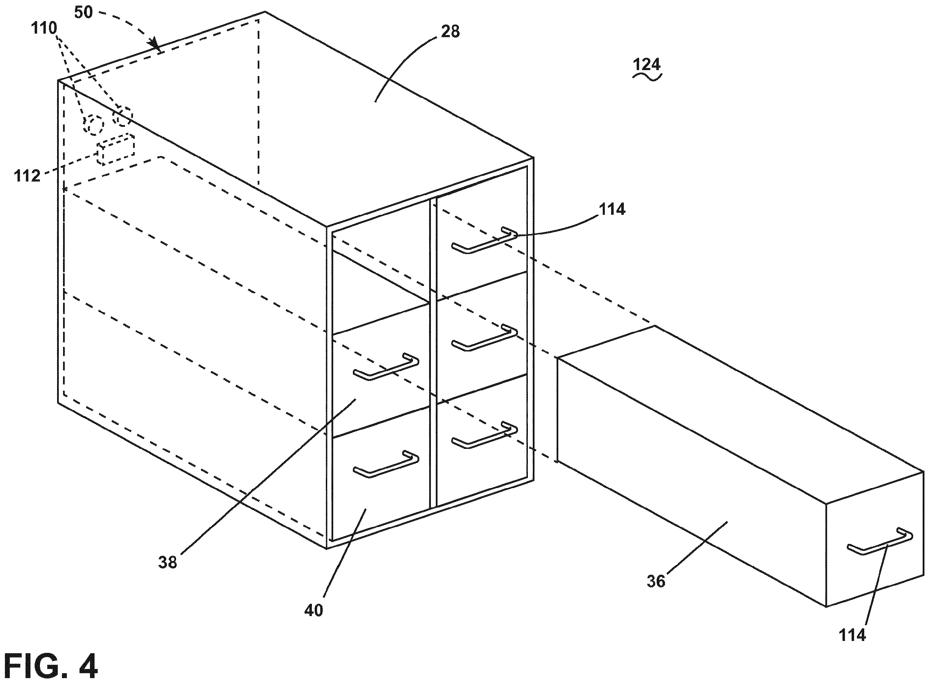

FIG. 4 illustrates a non-limiting isometric view of one example configuration of an energy storage unit 124. The energy storage unit 124 can be similar to the energy storage unit 24 described herein. As shown, the energy storage unit 124 can include user-removable or user-swappable power modules 36, 38, 40 receivable by the housing 28. As shown in dotted outline, the backplane 50 can be located at the inner rear portion or at the front of the housing 28, and can include a first set of power connectors 110, similar to the schematic power connectors 60 of FIGS. 2 and 3, as well as a communication connection 112, similar to the communication interfaces 62, 64 of FIG. 2. In non-limiting examples, the controller module 30 (not shown) can use both the communication connection 112 and power connectors 110 to determine the presence of the replaceable or removable power modules 36, 38, 40.

In another non-limiting example, the power modules 36, 38, 40 can include a user-interactive device, shown as a handle 114, to aid in facilitating the removal or swapping of the set of power modules 36, 38, 40. In this configuration, a user can operably swap (or "hot swap") a variety of power modules 36, 38, 40 during energy suppling operations, during maintenance operations, or when the power module 36, 38, 40 has been sufficiently discharged. In yet another non-limiting example of the disclosure, at least one of the power modules 36, 38, 40 or the backplane 50 (e.g. the communication connection 112 or the power connectors 110) can be universal in the sense the can receive any adapted or compatible power module 36, 38, 40, regardless of the energy storage cell 51. In another non-limiting example at least one of the power modules 36, 38, 40 or the backplane 50 (e.g. the communication connection 112 or the power connectors 110) can be keyed such that the power modules 36, 38, 40 can only be receive by the housing 28 or energy storage unit 24, 124 when in a correct orientation (e.g. that cannot be inserted incorrectly).

While aspects of the disclosure have been described and illustrated with respect to direct current (DC) power outputs, aspects of the disclosure can be applied to alternating current (AC) power outputs, or a combination of AC and DC power outputs. Furthermore, while the power modules 36, 38, 40 or energy storage cell 51 have been described with respect to discharging electrical power, non-limiting aspects of the disclosure can be included wherein the power modules 36, 38, 40 or energy storage cells 51 can include rechargeable electrical storage mechanisms, and wherein they can be recharged by the power distribution system 30.

Many other possible aspects and configurations in addition to that shown in the above figures are contemplated by the present disclosure.

The aspects disclosed herein provide a method and apparatus for selectably operating a set of AC or DC power outputs from a set of power sources, such as power modules. Additionally, the aspects provide for a method and apparatus for dynamically configuring the power output of the energy storage unit by way of the power output configuration module.

Non-limiting aspects of the disclosure include a system that combines advanced energy storage modules in a way to provide single or multiple output voltages and discharge modules in an optimized method to furnish either power or energy based on the load(s) demand. The system utilizes a standardized modular approach that integrates electric energy storage components such as battery cells, ultra/super-capacitors, superconducting magnetic energy storage (SMES), the like, or a combination thereof.

Battery cells are routinely packaged together to achieve higher output voltages or lower resistive losses (reduced ESR). However, when voltages increase by multiples of the base battery there are design challenges that must be addressed. The result is that there is not a single approach that allows someone to move up and down in voltages or choose methods to reduce electric losses because of human factors, safety, cell energy balancing, energy/power availability, efficiency, and charging algorithms are non-linear/non-obvious. Additionally, there are not systems that easily allow changing energy storage cells, configuration, or utilization of a combination of energy storage mediums (so -called hybrid energy storage methods).

New generations of electrical power system require adaptable energy sources that vary based on the modes of vehicle operation (whereby modes are the combination of environmental condition as well as vehicle functionality such as charging, motoring, climbing, descending, secondary devices), types of electrical loads (inductive/capacitive/resistive), duration of loads, and slew rates (described as A/ms, V/ms, or Power/ms).

Aspects of the disclosure allow for or enable a unique linkage of modules using an electromechanical backplane and methods of power distribution to dynamically adapt the energy storage performance characteristics (voltage, current, power, efficiency, rate) with respect to environmental (altitude, temperature, humidity, vibration) and electrical system load characteristics. Additionally, dynamic (e.g. continuous) control of energy or power is optimized (voltage, current, electrical losses) with respect to EPS demands and environmental factors are operable, in addition to, or based upon feedback from EPS. Alternatively, or in addition to the aforementioned control schema, dynamic (e.g. upon command) control can be enabled by way of user selections of desired parameters and system configures (or reconfigures) to meet it with respect to known energy storage components, automated safety with respect to module connections, environment. Furthermore, the system can operably controls switching matrix in order to prevent current spikes, arcing/corona, or the like.

In another non-limiting example, the system can include mechanisms for passively or actively balancing the power supply from the set of power modules 36, 38, 40.

To the extent not already described, the different features and structures of the various aspects can be used in combination with each other as desired. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described. Combinations or permutations of features described herein are covered by this disclosure.

Further aspects of the invention are provided by the subject matter of the following clauses:
1. A dynamic power supply system, including a set of energy storage units, each of the set of energy storage units having a power output, and a housing configured to receive the set of energy storage units and including an electrical backplane with a backplane power output, the electrical backplane connectable with the each of the set of energy storage unit power outputs, a power output configuration module adapted to selectably interconnect at least a subset of the energy storage unit power outputs with the backplane power output, and a controller module configured to operate the power output configuration module.
2. The dynamic power supply system of any preceding clause, further comprising a power demand input configured to receive a power demand for the dynamic power supply system.
3. The dynamic power supply system of any preceding clause wherein the controller module is further configured to operate the power output configuration module such that power supplied from the at least a subset of the energy storage unit power outputs to the backplane power output meets the power demand.
4. The dynamic power supply system of any preceding clause wherein the set energy storage units include at least a first energy storage unit comprising a first dischargeable energy source and at least a second energy storage unit comprising a second dischargeable energy source, wherein the second dischargeable energy source is different from the first dischargeable energy source.
5. The dynamic power supply system of any preceding clause wherein the controller module is configured to operate the power output configuration module such that power is supplied from the at least the first energy storage unit meets a first power demand, and wherein the controller module is configured to operate the power output configuration module such that power is supplied from the at least the second energy storage unit meets a second power demand.
6. The dynamic power supply system of any preceding clause wherein the first power demand is a transient power demand and the at least the first energy storage unit a supercapacitor-based energy storage unit or a chemical-based battery energy storage unit.
7. The dynamic power supply system of any preceding clause wherein the second power demand is a continuous power demand and the at least the second energy storage unit is a chemical-based battery energy storage unit.
8. The dynamic power supply system of any preceding clause where the set energy storage units include at least a first energy storage unit comprising a first dischargeable energy source and at least a second energy storage unit comprising a second dischargeable energy source, wherein the second dischargeable energy source different from the first dischargeable energy source.
9. The dynamic power supply system of any preceding clause wherein the electrical backplane defines a power connector that is common for receiving any of the set of energy storage units.
10. The dynamic power supply system of any preceding clause wherein the set of energy storage units are removably coupled with the housing such that a discharged energy storage unit can be removed and replaced with a charged energy storage unit.
11. The dynamic power supply system of any preceding clause wherein the backplane power output is connected with an aircraft power distributions system, and wherein the removing and replacing of discharged energy storage units occurs during maintenance operations.
12. The dynamic power supply system of any preceding clause wherein the power output configuration module is adapted to selectably interconnect at least a subset of the energy storage unit power outputs with the backplane power output in any permutation of electrical parallel or electrical series arrangements.
13. The dynamic power supply system of any preceding clause further comprising a power demand input configured to receive a power demand for the dynamic power supply system, and wherein the controller module is further configured to operate the power output configuration module such that the power supplied by way of the selectably interconnecting of the power output configuration module from the at least a subset of the energy storage unit power outputs to the backplane power output meets the power demand.
14. A dynamic power supply system for an aircraft power distribution system, including a set of energy storage units, each of the set of energy storage units having a power output, a set of sensors configured to generate sensor data related to the set of energy storage units, and a housing configured to receive the set of energy storage units and including an electrical backplane with a backplane power output connected with the aircraft power distribution system, the electrical backplane connectable with the each of the set of energy storage unit power outputs, a power output configuration module adapted to selectably interconnect at least a subset of the energy storage unit power outputs with the backplane power output, and a controller module communicatively connected with the set of sensors and configured to operate the power output configuration module base at least in part on the generated sensor data.
15. The dynamic power supply system of any preceding clause wherein the set of sensors include at least a subset of environmental sensors adapted to generate sensor data related to at least one of aircraft altitude, a temperature of at least a subset of the energy storage units, or a humidity.
16. The dynamic power supply system of any preceding clause wherein the set of sensors includes a temperature sensor associated with each of the set of energy storage units and configured to generate temperature data related to each of the set of energy storage units.
17. The dynamic power supply system of any preceding clause wherein the controller module is further configured to operate the power output configuration module based at least in part on temperature data.
18. The dynamic power supply system of any preceding clause wherein the electrical backplane is a planar element located at the rear of the housing.
19. The dynamic power supply system of any preceding clause wherein the power output configuration module comprises a set of solid state power controller switching devices.
20. The dynamic power supply system of any preceding clause wherein the housing is configured to removably receive the set of energy storage units, and wherein the set of energy storage units are replaceable without interrupting energy supplying operations of the dynamic power supply system.

This written description uses examples to disclose aspects of the disclosure, including the best mode, and also to enable any person skilled in the art to practice aspects of the disclosure, including making and using any devices or systems and performing any incorporated methods. The patentable scope of the disclosure is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A dynamic power supply system (26), comprising:
a set of energy storage units (24, 124), each of the set of energy storage units (24, 124) having a power output; and
a housing (28) configured to receive the set of energy storage units (24, 124) and including:
an electrical backplane (50) with a backplane power output (66), the electrical backplane (50) connectable with the each of the set of energy storage unit (24, 124) power outputs;
a power output configuration module (52) adapted to selectably interconnect at least a subset of the energy storage unit (24, 124) power outputs with the backplane power output (66); and
a controller module (30) configured to operate the power output configuration module (52).

2. The dynamic power supply system (26) of claim 1, further comprising a power demand input configured to receive a power demand for the dynamic power supply system (26).

3. The dynamic power supply system (26) of claim 1 or 2 wherein the controller module (30) is further configured to operate the power output configuration module (52) such that power supplied from the at least a subset of the energy storage unit (24, 124) power outputs to the backplane power output (66) meets the power demand.

4. The dynamic power supply system (26) of any of claims 1-3 wherein the set of energy storage units (24, 124) include at least a first energy storage unit (24, 124) comprising a first dischargeable energy source and at least a second energy storage unit (24, 124) comprising a second dischargeable energy source, wherein the second dischargeable energy source is different from the first dischargeable energy source.

5. The dynamic power supply system (26) of claim 4 wherein the controller module (30) is configured to operate the power output configuration module (52) such that power is supplied from the at least the first energy storage unit (24, 124) meets a first power demand, and wherein the controller module (30) is configured to operate the power output configuration module (52) such that power is supplied from the at least the second energy storage unit (24, 124) meets a second power demand.

6. The dynamic power supply system (26) of claim 5 wherein the first power demand is a transient power demand and the at least the first energy storage unit (24, 124) a supercapacitor-based energy storage unit (24, 124) or a chemical-based battery energy storage unit (24, 124).

7. The dynamic power supply system (26) of claim 5 or 6 wherein the second power demand is a continuous power demand and the at least the second energy storage unit (24, 124) is a chemical-based battery energy storage unit (24, 124).

8. The dynamic power supply system (26) of any of claims 1-7 where the set of energy storage units (24, 124) include at least a first energy storage unit (24, 124) comprising a first dischargeable energy source and at least a second energy storage unit (24, 124) comprising a second dischargeable energy source, wherein the second dischargeable energy source different from the first dischargeable energy source.

9. The dynamic power supply system (26) of any of claims 1-8 wherein the electrical backplane (50) defines a power connector (60) that is common for receiving any of the set of energy storage units (24, 124).

10. The dynamic power supply system (26) of any of claims 1-9 wherein the power output configuration module (52) is adapted to selectably interconnect at least a subset of the energy storage unit (24, 124) power outputs with the backplane power output (66) in any permutation of electrical parallel or electrical series arrangements.

11. The dynamic power supply system (26) of claim 10 further comprising a power demand input configured to receive a power demand for the dynamic power supply system (26), and wherein the controller module (30) is further configured to operate the power output configuration module (52) such that the power supplied by way of the selectably interconnecting of the power output configuration module (52) from the at least a subset of the energy storage unit (24, 124) power outputs to the backplane power output (66) meets the power demand.

12. A dynamic power supply system (26) for an aircraft power distribution system, comprising:
a set of energy storage units (24, 124), each of the set of energy storage units (24, 124) having a power output;
a set of sensors (80) configured to generate sensor data related to the set of energy storage units (24, 124); and
a housing (28) configured to receive the set of energy storage units (24, 124) and including:
an electrical backplane (50) with a backplane power output (66) connected with the aircraft power distribution system, the electrical backplane (50) connectable with the each of the set of energy storage unit (24, 124) power outputs;
a power output configuration module (52) adapted to selectably interconnect at least a subset of the energy storage unit (24, 124) power outputs with the backplane power output (66); and
a controller module (30) communicatively connected with the set of sensors (80) and configured to operate the power output configuration module (52) base at least in part on the generated sensor data.

13. The dynamic power supply system (26) of claim 12 wherein the set of sensors (80) include at least a subset of environmental sensors adapted to generate sensor data related to at least one of aircraft altitude, a temperature of at least a subset of the energy storage units (24, 124), or a humidity.

14. The dynamic power supply system (26) of claim 12 or 13 wherein the set of sensors (80) includes a temperature sensor associated with each of the set of energy storage units (24, 124) and configured to generate temperature data related to each of the set of energy storage units (24, 124).

15. The dynamic power supply system (26) of any of claims 12-14 wherein the housing (28) is configured to removably receive the set of energy storage units (24, 124), and wherein the set of energy storage units (24, 124) are replaceable without interrupting energy supplying operations of the dynamic power supply system (26).
